# EUROPÄISCHE PATENTSCHRIFT

(11) **EP 3 535 594 B1**
(45) Veröffentlichungstag und Bekanntmachung des Hinweises auf die Patenterteilung: **29.03.2023**
(21) Anmeldenummer: 18702099.5
(22) Anmeldetag: 11.01.2018
(51) Int. Cl.: G01R 33/36, G01R 33/341, G01R 33/3415, G01R 33/34

(54) **MAGNETRESONANZTOMOGRAPH UND LOKALSPULENMATRIX ZUM BETRIEB BEI NIEDRIGEN MAGNETFELDSTÄRKEN**
MAGNETIC RESONANCE SCANNER AND LOCAL COIL MATRIX FOR OPERATION AT LOW MAGNETIC FIELD STRENGTHS
TOMOGRAPHE À RÉSONANCE MAGNÉTIQUE ET MATRICE DE BOBINES LOCALES PERMETTANT UN FONCTIONNEMENT À DES INTENSITÉS DE CHAMP MAGNÉTIQUE PEU ÉLEVÉES

(30) Priorität: 13.01.2017 DE 102017200511
(43) Veröffentlichungstag der Anmeldung: 11.09.2019
(73) Patentinhaber: Siemens Healthcare GmbH, 91052 Erlangen (DE)
(72) Erfinder: MIOSGA, Michael, 86163 Augsburg (DE); REHNER, Robert, 91077 Neunkirchen am Brand (DE); VESTER, Markus, 90471 Nürnberg (DE)
(86) Internationale Anmeldenummer: PCT/EP2018/050662
(87) Internationale Veröffentlichungsnummer: WO 2018/130614

(56) Entgegenhaltungen:
- DE-A1- 4 218 635
- DE-A1-102012 206 008
- US-A1- 2011 074 415
- US-A1- 2016 033 592
- HIROYUKI FUJITA ET AL: "RF Surface Receive Array Coils: The Art of an LC Circuit : RF Surface Receive Array Coils", JOURNAL OF MAGNETIC RESONANCE IMAGING, Bd. 38, Nr. 1, 6. Mai 2013 (2013-05-06), Seiten 12-25, XP055467973, US ISSN: 1053-1807, DOI: 10.1002/jmri.24159
- DOTY F D ET AL: "Radio frequency coil technology for small-animal MRI", NMR IN BIOMEDICINE, WILEY, LONDON, GB, Bd. 20, 24. April 2007 (2007-04-24), Seiten 304-325, XP002463820, ISSN: 0952-3480, DOI: 10.1002/NBM.1149

## Beschreibung

Die Erfindung betrifft eine Lokalspulenmatrix und einen Magnetresonanztomographen zum Betrieb bei niedrigen Magnetfeldstärken.

Magnetresonanztomographen sind bildgebende Vorrichtungen, die zur Abbildung eines Untersuchungsobjektes Kernspins des Untersuchungsobjektes mit einem starken äußeren Magnetfeld ausrichten und durch ein magnetisches Wechselfeld zur Präzession um diese Ausrichtung anregen. Die Präzession bzw. Rückkehr der Spins aus diesem angeregten in einen Zustand mit geringerer Energie wiederum erzeugt als Antwort ein magnetisches Wechselfeld, auch als Magnetresonanzsignal bezeichnet, das über Antennen empfangen wird.

Mit Hilfe von magnetischen Gradientenfeldern wird den Signalen eine Ortskodierung aufgeprägt, die nachfolgend eine Zuordnung von dem empfangenen Signal zu einem Volumenelement ermöglicht. Das empfangene Signal wird dann ausgewertet und eine dreidimensionale bildgebende Darstellung des Untersuchungsobjektes bereitgestellt. Die erzeugte Darstellung gibt eine räumliche Dichteverteilung der Spins an.

Üblicherweise werden heute in Magnetresonanztomographen Magnetfelder von 1,5 Tesla, 3 Tesla oder höher als B0-Feld zur Ausrichtung der Kernspins verwendet. Da die Larmorfrequenz mit der B0-Feldstärke linear ansteigt, verschiebt sich die Larmorfrequenz in Bereiche von 70 MHz bis hin zu 150MHz und darüber. Dies bringt den Vorteil, dass bei einer höheren Frequenz Rauschanteile abnehmen. Die dazu erforderlichen Magnete werden aber gleichzeitig wegen der wachsenden inneren Kräfte immer schwerer und teurer. Auch nehmen die in den Feldern gespeicherten Energien zu, sodass für einen Ausfall der Supraleitung immer aufwändigere Sicherheitsmaßnahmen ergriffen werden müssen.

Insbesondere für kostengünstige Magnetresonanztomographen besteht daher ein Interesse, die erforderlichen Aufwände für den Feldmagneten zu reduzieren.

Bei niedrigeren B0-Feldstärken und den entsprechend niedrigeren Larmorfrequenzen von 30 MHz und darunter wird vom Körper eines Patienten weniger Leistung aus dem elektromagnetischen Wechselfeld einer Sende- und/oder Empfangsspule absorbiert. Die Güte der Spule steigt an, sodass zwar auf der einen Seite die Amplitude eines Empfangssignals mit der Larmorfrequenz ansteigt. Auf der anderen Seite steigt damit auch die Wechselwirkung benachbarter Spulen, beispielsweise in einer Lokalspulenmatrix an. Die stärkeren Wechselwirkungen verursachen Verschiebungen von Resonanzfrequenzen der Spulen, sodass sich insgesamt das Signal-zu Rauschverhältnis verschlechtert.

Aus dem Dokument DE 10 2012 206008 A1 ist Magnetresonanzspulenanordnung bekannt, die wenigstens zwei Spulenelemente aufweist, die über einen Verstärker auslesbar und/oder ansteuerbar sind, und eine Anpassungsschaltung zur Leistungs- und/oder Rauschanpassung zwischen dem Spulenelement und dem Verstärker. Die Bauteile der Anpassungsschaltung sind zu einer Breitbandanpassung auf ein Frequenzband dimensioniert, wobei das Frequenzband durch die äußersten relevanten, aufgrund der Wechselwirkung eines Spulenelements mit wenigstens einem benachbarten Spulenelement auftretenden, von der Resonanzfrequenz verschobenen Kopplungsmoden begrenzt wird.

Es ist daher eine Aufgabe der vorliegenden Erfindung, eine Lokalspulenmatrix und einen Magnetresonanztomographen für niedrige statische Magnetfeldstärken mit einer verbesserten Bildgebung bereitzustellen.

Die Aufgabe wird durch eine erfindungsgemäße Lokalspulenmatrix nach Anspruch 1 und den erfindungsgemäßen Magnetresonanztomographen nach Anspruch 14 sowie durch das Verfahren zum Betrieb nach Anspruch 17 gelöst.

Die erfindungsgemäße Lokalspulenmatrix für einen Magnetresonanztomograph mit niedrigem statischem Magnetfeld B0 weist eine erste Spulenwicklungen und eine zweite Spulenwicklung und jeweils mit einer Spulenwicklung elektrisch verbundene rauscharme erste Vorverstärker und zweite Vorverstärker auf. Die erste Spulenwicklung weist dabei eine Breitbandanpassung in einem ersten Frequenzbereich bei einer Larmorfrequenz an dem damit verbundenen ersten Vorverstärker auf. In einer bevorzugten Ausführungsform weist auch die zweite Spulenwicklung eine Breitbandanpassung auf.

Als Larmorfrequenz wird die Frequenz angesehen, die einer Resonanzfrequenz der zu erfassenden Kernspins in einem statischen Magnetfeld niedriger Feldstärke, insbesondere einer Feldstärke kleiner gleich 1,5 T, 1 T oder 0,5 T entspricht.

Als Breitbandanpassung wird hierbei eine Anpassung angesehen, die bei einer Abweichung einer Spulenresonanzfrequenz von der Larmorfrequenz um 1% eine Verringerung des Signal-zu-Rauschabstandes (SNR) an dem Vorverstärker um weniger als 6 dB bei der Larmorfrequenz verursacht.

Auf vorteilhafte Weise ermöglicht eine Lokalspulenmatrix mit einer Breitbandanpassung bei der Larmorfrequenz bei mehreren benachbarten Spulen wegen der durch die Wechselwirkung der Spulen verschobenen Resonanzfrequenzen einen verbesserten Empfang mit besserem Signal-zu-Rausch-Verhältnis.

Weitere Vorteile der erfindungsgemäßen Lokalspulenmatrix, Magnetresonanztomographen und Verfahrens zum Betrieb sind in den abhängigen Unteransprüchen angegeben.

In einer denkbaren Ausführungsform der erfindungsgemäßen Lokalspulenmatrix ist die erste Spulenwicklung zur zweiten Spulenwicklung benachbart angeordnet. Die erste und die zweite Spulenwicklungen bilden je einen ersten Resonanzkreis und einen zweiten Resonanzkreis, die ein gekoppeltes System aus erster Spulenwicklung und zweiter Spulenwicklung bilden mit einer erste Resonanzfrequenz und eine zweite Resonanzfrequenz. Die Kopplung erfolgt beispielsweise durch das Magnetfeld der ersten Spulenwicklung, das auf die zweite Spulenwicklung übergreift und umgekehrt. Die Spulenwicklungen bilden dabei aufgrund der Eigenkapazität und verbundener Komponenten Resonanzkreise. Dabei sind die erste Resonanzfrequenz und die zweite Resonanzfrequenz des gekoppelten Systems unterschiedlich und liegen in dem ersten Frequenzbereich der Breitbandanpassung. Der erste Frequenzbereich der Breitbandanpassung kann beispielsweise 100 kHz, 500 kHz, 1 MHz oder 2 MHz um die Larmorfrequenz liegen.

Indem beide Resonanzfrequenzen in dem Bereich der Breitbandanpassung liegen, kann auf vorteilhafte Weise der Aufwand zur Unterdrückung einer Kopplung reduziert werden, ohne durch Fehlanpassung zu viel Signal-zu-Rauschverhältnis zu verlieren.

In einer möglichen Ausführungsform der erfindungsgemäßen Lokalspulenmatrix weist die erste Spulenwicklung eine Mehrzahl an Windungen auf. Vorzugsweise weist auch die zweite Spulenwicklung eine Mehrzahl an Windungen auf.

Auf vorteilhafte Weise weist eine Spule mit mehreren Windungen eine höhere Impedanz auf, sodass ein Anpassungsnetzwerk an einen nachfolgenden Vorverstärker mit höherer Eingangsimpedanz einfach und mit geringeren Verlusten ausgelegt werden oder auch ganz entfallen kann, was insbesondere in Verbindung mit den nachfolgend besprochenen rauscharmen Transistoren von Vorteil sein kann.

In einer ausserhalb der vorliegenden Erfindung liegenden Ausgestaltung der Lokalspulenmatrix steht die erste Spulenwicklung direkt ohne ein Anpassungsnetzwerk mit dem ersten Vorverstärker in Signalverbindung. Vorzugsweise steht auch die zweite Spulenwicklung direkt ohne ein Anpassungsnetzwerk mit dem zweiten Vorverstärker in Signalverbindung.

Wie zuvor erwähnt, kann es insbesondere bei Verwendung von rauscharmen Transistoren, auch in Verbindung mit Spulen mit mehreren Windungen, von Vorteil sein, den Vorverstärker direkt mit der Spulenwicklung zu verbinden, ohne ein Anpassungsnetzwerk, das eine Impedanztransformation ausführt und/oder verlustbehaftet ist. Als Impedanztransformation kann dabei z.B. ein Faktor von mehr als 2 bzw. weniger als 0,5 zwischen Eingangsimpedanz und Ausgangsimpedanz des Systems der Schaltelemente zwischen Spule und Vorverstärker angesehen werden. Es kann dabei auch eine Verbindung durch einen niederohmigen Leiter (< 1 Ohm) mit einer Länge kleiner einem Zehntel der Wellenlänge eines Signals mit Larmorfrequenz auf dem Leiter vorgesehen sein. Es ist dabei von besonderem Vorteil, dass bei einer Verstimmung der Resonanzfrequenz der Spulenwicklung, beispielsweise durch Wechselwirkung mit der zweiten Spulenwicklung bei veränderter Geometrie, der Rauschstrom des Vorverstärkers an der Impedanz der Spulenwicklung eine gegenüber einer idealen Anpassung kleinere Rauschspannung hervorruft. Als ideale Anpassung wird es bezeichnet, wenn die - optional durch das Anpassungsnetzwerk transformierte - Impedanz der Spulenwicklung der Eingangsimpedanz des Vorverstärkers entspricht.

In einer möglichen Ausführungsform der erfindungsgemäßen Lokalspulenmatrix weist die Lokalspulenmatrix ein Anpassungsnetzwerk in Signalverbindung mit der ersten Spulenwicklung und dem ersten Vorverstärker auf. Als Anpassungsnetzwerk wird dabei eine Schaltung elektrischer Bauelemente angesehen, die für ein Signal bei der Larmorfrequenz eine Impedanztransformation zwischen Signaleingang und Signalausgang ausführt. Als Impedanztransformation kann dabei z.B. ein Faktor von mehr als 2 bzw. weniger als 0,5 zwischen Eingangsimpedanz und Ausgangsimpedanz des Systems der Schaltelemente zwischen Spule und Vorverstärker angesehen werden. Die Impedanz des Systems aus Anpassungsnetzwerk und erster Spulenwicklung ist dabei kleiner als eine Eingangsimpedanz des ersten Vorverstärkers. Der Betrag der Impedanz kann dabei beispielsweise um den Faktor 2, 5, 10, 20, 50, 100 oder höher kleiner sein.

Das Anpassungsnetzwerk ermöglicht auf vorteilhafte Weise eine Änderung der durch Spulenwicklung und Anpassungsnetzwerk am Vorverstärker anliegenden Quellenimpedanz. Indem die Impedanz des Systems aus Spulenwicklung und Anpassungsnetzwerk kleiner als die Eingangsimpedanz des Vorverstärkers ist, erzeugt ein Rauschstrom des Vorverstärkers bei einem Verstimmen der ersten Spulenwicklung eine geringere Erhöhung des Rauschens. Auf vorteilhafte Weise kann so eine Lokalspulenmatrix gegen Verstimmung der Resonanzfrequenzen durch den Patienten oder durch Geometrieänderungen unempfindlich gemacht werden.

In einer denkbaren Ausführungsform der erfindungsgemäßen Lokalspulenmatrix ist das Anpassungsnetzwerk so ausgelegt, dass ein durch einen Rauschstrom des ersten Vorverstärkers an der Impedanz des Systems aus Anpassungsnetzwerk und erster Spulenwicklung bei einer Verstimmung der ersten Spulenwicklung verursachte Anstieg des Rauschens im Signal kleiner einem vorbestimmten Grenzwert ist.

Die Verstimmung kann beispielsweise mehr als 0,1%, 1%, 2%, 5% oder 10% der Resonanzfrequenz, d.h. der Larmorfrequenz des Magnetresonanztomographen betragen. Bei einer Verstimmung nimmt unter anderem die durch den Rauschstrom des Vorverstärkers an der Impedanz des Systems aus Anpassungsnetzwerk und Spulenwicklung hervorgerufene Rauschspannung zu. Der vorbestimmte Grenzwert kann beispielsweise eine Zunahme des Rauschens um 1 dB, 3 dB, 6dB oder 12 dB gegenüber dem Rauschsignal bei der Resonanzfrequenz sein

In einer nicht beanspruchten Ausführungsform der erfindungsgemäßen Lokalspulenmatrix weist der Vorverstärker einen E-PHEMT aufweist (Enhancement mode Pseudomorphic High Electron Mobility Transistor).

Der E-PHEMT ist ein Transistortyp mit einem besonders niedrigen Eigenrauschen. Das besonders niedrige Eigenrauschen erlaubt es auf vorteilhafte Weise, eine Verschlechterung des Signal-zu-Rauschverhaltens (SNR) ohne Verstimmung der Spulenwicklung durch die Breitbandanpassung gegen einen reduzierten Anstieg des Rauschens bei Verstimmung der Spulenwicklung einzutauschen, ohne im Idealfall ohne Verstimmung eine Reduzierung der Bildqualität gegenüber Vorverstärkern mit herkömmlichen Transistoren zu verursachen. Damit wird die Handhabung und das Design der Lokalspulen vereinfacht und die Bildqualität reproduzierbarer.

Es ist auch denkbar, dass ein besonders niedriges Rauschen durch eine Kühlung des Vorverstärkers erreicht wird, alternativ oder in Verbindung mit besonders rauscharmen Transistortypen.

In einer möglichen Ausführungsform der erfindungsgemäßen Lokalspulenmatrix weist die Lokalspulenmatrix ein über eine Steuerverbindung einstellbares erstes Anpassungsnetzwerk in Signalverbindung mit der ersten Spulenwicklung auf. Vorzugsweise weist die erfindungsgemäße Lokalspulenmatrix auch ein über eine Steuerverbindung einstellbares zweites Anpassungsnetzwerk in Signalverbindung mit der zweiten Spulenwicklung auf, wobei in diesem Fall das erste Anpassungsnetzwerk und das zweite Anpassungsnetzwerk vorzugsweise unabhängig voneinander sind.

Ein einstellbares Anpassungsnetzwerk ermöglicht auf vorteilhafte Weise, die Empfangseigenschaften der Lokalspulenmatrix auf unterschiedliche Bedingungen, beispielsweise unterschiedliche Abstände zum Körper des Patienten oder eine andere Physiognomie anzupassen.

In einer denkbaren Ausführungsform der erfindungsgemäßen Lokalspulenmatrix ist das einstellbare erste Anpassungsnetzwerk ausgelegt, die erste Resonanzfrequenz der ersten Spulenwicklung und/oder die Breitbandanpassung des ersten Vorverstärkers zu verändern. Beispielsweise kann eine spannungsveränderliche Kapazität wie eine PIN-Diode in dem Anpassungsnetzwerk vorgesehen sein. Vorzugsweise gilt das gleiche für das zweite Anpassungsnetzwerk und den zweiten Vorverstärker.

Eine einstellbare Resonanzfrequenz und/oder Breitbandanpassung ermöglicht es auf vorteilhafte Weise, die Empfindlichkeit der Lokalspulenmatrix auf eine durch das Magnetfeld vorgegebene Larmorfrequenz zu optimieren.

In einer möglichen Ausführungsform der erfindungsgemäßen Lokalspulenmatrix ist das Anpassungsnetzwerk ausgebildet, eine vorbestimmte Schwingungsmode in Abhängigkeit von einer Einstellung über die Steuerverbindung in den Signalen der ersten Spulenwicklung und der zweiten Spulenwicklung auszuwählen. Beispielsweise können durch geeignete Einstellung von veränderlichen Kapazitäten bestimmte Moden bevorzugt werden. Die einzelnen Moden unterscheiden sich in der Resonanzfrequenz, sodass beispielsweise das Anpassungsnetzwerk die Resonanzfrequenz einer Mode beeinflussen und in Übereinstimmung mit der Larmorfrequenz bringen kann. Diese Mode trägt dann in erhöhtem Maß zum Empfangssignal der Lokalspulenmatrix bei. Als bevorzugt in dem Signal kann dabei beispielsweise angesehen werden, wenn eine Amplitude der bestimmten Mode in dem Signal um mindestens 1 dB, 3 dB, 6 dB oder 12 dB gegenüber Amplituden anderer Moden angehoben wird.

Auf vorteilhafte Weise können durch eine Auswahl bestimmter Moden beispielsweise bestimmte zu untersuchende Regionen in unterschiedlicher Tiefe mit besserer Signalqualität erfasst werden, indem Moden mit maximaler Sensitivität in dieser Region bevorzugt werden.

In einer denkbaren Ausführungsform der erfindungsgemäßen Lokalspulenmatrix weisen die erste Spulenwicklung und eine zweite Spulenwicklung ein gemeinsames Spulenleitersegment und ein Entkopplungselement auf. Beispielsweise können die Spulenwicklungen in Form einer "8" ausgeführt sein. Als Entkopplungselement kann dann eine Kapazität in einem gemeinsamen Leiterstück eingefügt sein, das in der Mitte der "8" angeordnet ist. Das Anpassungsnetzwerk ist dabei einstellbar, eine Schwingungsmode aus den Signalen der ersten Spulenwicklung und der zweiten Spulenwicklung zu bevorzugen, bei der ein Strom durch das Entkopplungselement reduziert ist.

Über eine geeignete Einstellung variabler Kapazitäten in dem Anpassungsnetzwerk kann so auf vorteilhafte Weise beispielsweise eine Schwingungsmode der ersten und zweiten Spulenwicklung ausgewählt werden, für die der Einfluss des Entkopplungselements z.B. durch ohmsche oder dielektrische Verluste auf das auszuwertende Signal minimiert ist.

In einer möglichen Ausführungsform der erfindungsgemäßen Lokalspulenmatrix weist die erste Spulenwicklung ein erstes leitendes Segment und ein zweites leitendes Segment auf, die elektrisch voneinander isoliert sind. Beispielsweise können das erste und das zweite Spulensegment als Leiterbahn auf zwei gegenüberliegenden Oberflächen eines Substrats angeordnet sein. Das erste leitende Segmente und das zweite leitende Segment weisen jeweils eine Fläche auf, die in Projektion senkrecht zu den Oberflächen miteinander überlappen und voneinander isoliert sind. Mit dem dazwischenliegenden Substrat oder einem anderen verlustarmen Dielektrikum dazwischen bilden die beiden überlappenden Flächen der Leitersegmente eine Kapazität zwischen den beiden Leitersegmenten.

Auf vorteilhafte Weise bilden die überlappenden Leiterflächen mit dem Dielektrikum eine verlustarme Kapazität, die eine Spulenwicklung mit hoher Güte ermöglicht.

In einer denkbaren Ausführungsform der erfindungsgemäßen Lokalspulenmatrix weist die Lokalspulenmatrix eine Signalleitung zum Anschluss an einen Magnetresonanztomographen mit einer ohmschen Mantelwellensperre auf.

Bei niedrigerer Magnetfeldstärke und einer daraus resultierenden niedrigeren Larmorfrequenz ist eine Einkopplung eines Anregungspulses des Magnetresonanztomographen in eine Signalleitung bei gleicher Länge geringer. Es ist daher auf vorteilhafte Weise möglich, eine ohmsche Mantelwellensperre vorzusehen, die auch keine genaue Abstimmung auf eine bestimmte Frequenz erfordert.

In einer möglichen Ausführungsform der erfindungsgemäßen Lokalspulenmatrix weist die Lokalspulenmatrix eine Signalleitung zum Anschluss an einen Magnetresonanztomographen mit einer symmetrischen Zweidrahtleitung auf. Vorzugsweise ist die Lokalspule ausgelegt, über beide Leiter der Zweidrahtleitung jeweils ein Resonanzsignal der Kernspins zu übertragen. Als symmetrische Zweidrahtleitung wird dabei ein Paar von Leitern angesehen, die einem vorbestimmten Abstand zueinander, durch ein Dielektrikum voneinander isoliert, geführt werden. Die beiden Leiter sind vorzugsweise von einer gemeinsamen leitenden Abschirmung umgeben. Beispiele für derartige Zweidrahtleitungen sind CAT-Kabel in der LAN-Verkabelung, die paarweise verdrillte Leiterpaare und eine gemeinsame Abschirmung aufweisen.

Auf vorteilhafte Weise ermöglicht eine niedrigere Larmorfrequenz und auch eine damit verbundene geringere Einkopplung aus den Anregungspulsen die Verwendung kostengünstiger symmetrischer Zweidrahtleitungen zur Übertragung von Hochfrequenzsignalen zwischen Lokalspulenmatrix und Magnetresonanztomograph.

In einer denkbaren Ausführungsform der erfindungsgemäßen Lokalspulenmatrix weist die Lokalspulenmatrix eine Signalleitung zum Anschluss an einen Magnetresonanztomographen auf. An der Signalleitung ist ein Steckverbinder vorgesehen mit einer Mehrzahl an Signalkontakten. In dem Steckverbinder ist eine Mehrzahl an Signalkontakt von einer Mehrzahl an Massekontakten umgeben. Mit anderen Worten, in zwei, drei oder mehr unterschiedlichen Richtungen in einer Ebene, die im Wesentlichen senkrecht zu einer Richtung ist, in die der Steckverbinder mit einem entsprechenden Gegenstück zur Kontaktgabe zusammengeführt wird, sind die nächsten Nachbarn eines Signalkontaktes Massekontakte. Vorzugsweise ist jeweils zwischen einem Signalkontakt und einem benachbarten Signalkontakt ein Massekontakt angeordnet.

Auf vorteilhafte Weise bildet die erfindungsgemäße Anordnung von Signalkontakten umgeben von Massekontakten einen Koaxialanschluss nach, was insbesondere bei den niedrigen Frequenzen unterhalb von 30 MHz eines erfindungsgemäßen Magnetresonanztomographen auf kostengünstige Weise aufwändige Koaxialstecker ersetzt.

In einer denkbaren Ausführungsform des erfindungsgemäßen Magnetresonanztomographen weist dieser eine Magnetfeldkamera mit einer Yttrium-Eisen-Granat-(YIG)Probe auf. Eine YIG-Probe weist eine Elektronen-Spin-Resonanz auf, die bei beispielsweise bei einer niedrigen B0-Magnetfeldstärke des erfindungsgemäßen Magnetresonanztomographen im Bereich von 20 bis 30 GHz liegt und durch kommerziell erhältliche Technik empfangbar ist.

Auf vorteilhafte Weise ist durch die gegenüber herkömmlichen Magnetresonanztomographen mit Feldkameras auf Kernspinresonanz höhere Frequenz der Rauschabstand einer Feldkamera mit YIG-wesentlich besser und leichter auszuwerten, während eine Verwendung einer YIG-Probe bei herkömmlichen Magnetresonanztomographen mit B0-Feldern von 1,5 T, 3 T oder mehr aufgrund der zu hohen Elektronenspin-Resonanzfrequenz nicht mehr mit kommerziell erhältlichen Mitteln möglich ist.

Das erfindungsgemäße Verfahren teilt die Vorteile der erfindungsgemäßen Lokalspulenmatrix und des erfindungsgemäßen Magnetresonanztomographen.

Weitere Vorteile und Einzelheiten ergeben sich aus der nachfolgenden Beschreibung von Ausführungsbeispielen in Verbindung mit den Zeichnungen. Es zeigen in Prinzipdarstellung:
- Fig. 1: einen erfindungsgemäßen Magnetresonanztomographen;
- Fig. 2: eine erfindungsgemäße Lokalspulenmatrix;
- Fig. 3: eine Signalverbindung einer erfindungsgemäßen Lokalspule;
- Fig. 4: eine schematische Darstellung einer Spule und eines Vorverstärkers einer erfindungsgemäßen Lokalspulenmatrix;
- Fig. 5: ein schematisches Ersatzschaltbild für Fig. 4 zur Abschätzung des Rauschverhaltens;
- Fig. 6: eine schematische Darstellung eines beispielhaften Anpassungsnetzwerkes einer erfindungsgemäßen Lokalspulenmatrix.

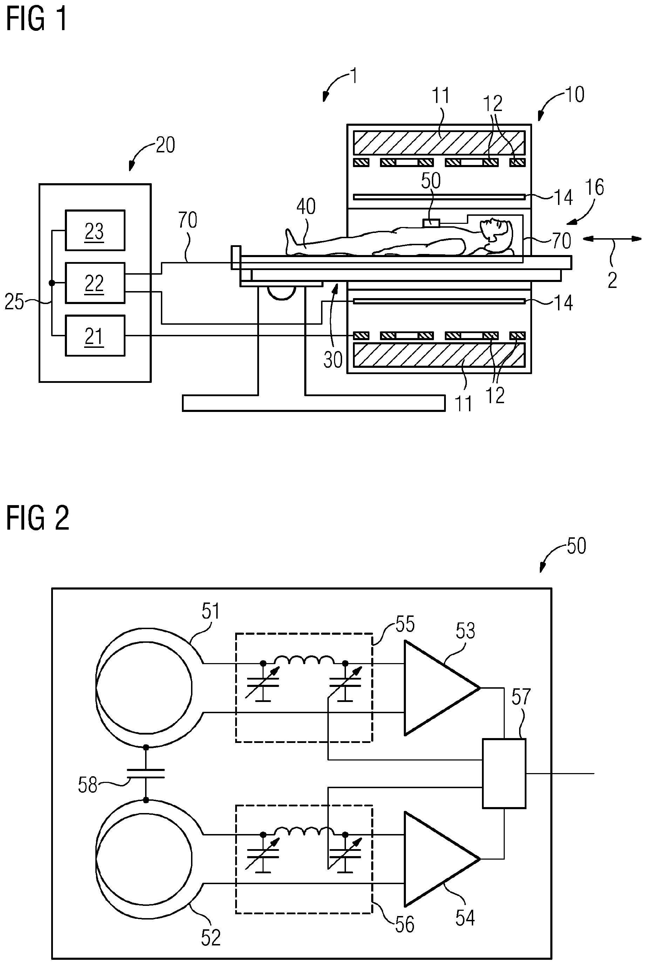

Fig. 1 zeigt eine schematische Darstellung einer Ausführungsform eines erfindungsgemäßen Magnetresonanztomographen 1.

Die Magneteinheit 10 weist einen Feldmagneten 11 auf, der ein statisches Magnetfeld B0 zur Ausrichtung von Kernspins von Proben bzw. in einem Körper eines Patienten 40 in einem Aufnahmebereich erzeugt. Der Aufnahmebereich ist in einem Patiententunnel 16 angeordnet, der sich in einer Längsrichtung 2 durch die Magneteinheit 10 erstreckt. In der bevorzugten Ausführungsform des erfindungsgemäßen Magnetresonanztomographen 1 handelt es sich bei dem Feldmagneten 11 um einen supraleitenden Magneten, der magnetische Felder mit einer magnetischen Flussdichte von 1 T oder weniger bereitstellen kann. Die relativ niedrige Feldstärke reduziert auf vorteilhafte Weise die Größe und Materialaufwand für den Feldmagneten einschließlich der laufenden Betriebskosten. Prinzipiell können auch Permanentmagnete oder Elektromagnete mit normalleitenden Spulen Verwendung finden.

Weiterhin weist die Magneteinheit 10 Gradientenspulen 12 auf, die dazu ausgelegt sind, zur räumlichen Differenzierung der erfassten Abbildungsbereiche in dem Untersuchungsvolumen dem Magnetfeld B0 variable Magnetfelder in drei Raumrichtungen zu überlagern. Die Gradientenspulen 12 sind üblicherweise Spulen aus normalleitenden Drähten, die zueinander orthogonale Felder in dem Untersuchungsvolumen erzeugen können.

Die Magneteinheit 10 weist ebenfalls eine Körperspule 14 auf, die dazu ausgelegt ist, ein über eine Signalleitung zugeführtes Hochfrequenzsignal in das Untersuchungsvolumen abzustrahlen und von dem Patient 40 emittierte Resonanzsignale zu empfangen und über eine Signalleitung abzugeben. Weiterhin weist der erfindungsgemäße Magnetresonanztomograph eine oder mehrere Lokalspulenmatrizen 50 auf, die in dem Patiententunnel 16 nahe am Patient 40 angeordnet sind.

Eine Steuereinheit 20 versorgt die Magneteinheit 10 mit den verschiedenen Signalen für die Gradientenspulen 12 und die Körperspule 14 und wertet die empfangenen Signale aus.

So weist die Steuereinheit 20 eine Gradientenansteuerung 21 auf, die dazu ausgelegt ist, die Gradientenspulen 12 über Zuleitungen mit variablen Strömen zu versorgen, welche zeitlich koordiniert die erwünschten Gradientenfelder in dem Untersuchungsvolumen bereitstellen.

Weiterhin weist die Steuereinheit 20 eine Hochfrequenzeinheit 22 auf, die ausgelegt ist, einen Hochfrequenz-Puls mit einem vorgegebenen zeitlichen Verlauf, Amplitude und spektraler Leistungsverteilung zur Anregung einer Magnetresonanz der Kernspins in dem Patienten 40 zu erzeugen. Dabei können Pulsleistungen im Bereich von Kilowatt erreicht werden. Die Hochfrequenzeinheit 22 weist dazu einen Hochfrequenzgenerator auf, der beispielsweise als Frequenzsynthesizer implementiert sein kann, der durch numerische Werte gesteuert wird. Die einzelnen Einheiten sind über einen Signalbus 25 untereinander verbunden.

Das von der Hochfrequenzeinheit 22 erzeugte Hochfrequenzsignal wird über eine Signalverbindung der Körperspule 14 zugeführt und in den Patiententunnel 16 abgestrahlt. Denkbar ist aber auch ein Aussenden des Hochfrequenzsignals über eine Lokalspule, die an dem Patienten angeordnet ist, möglicherweise auch über die Lokalspulenmatrix 50.

Die Lokalspulenmatrix 50 empfängt dann vorzugsweise ein Magnetresonanzsignal aus dem Körper des Patienten 40, denn aufgrund des geringen Abstandes ist das Signal-zu-Rauschverhältnis (SNR) der Lokalspulenmatrix 50 besser als bei einem Empfang durch die Körperspule 14. Das von der Lokalspulenmatrix 50 empfangene MR-Signal wird in der Lokalspulenmatrix 50 aufbereitet und an die Hochfrequenzeinheit 22 des Magnetresonanztomographen 1 zur Auswertung und Bilderfassung weitergeleitet. Vorzugsweise wird dazu ebenfalls die Signalverbindung 70 genutzt, es sind aber auch separate Signalverbindungen oder eine drahtlose Übertragung denkbar. Es ist ebenso denkbar, dass für das Empfangen eigene Lokalspulenmatrizen 50 oder andere Antennen vorgesehen sind.

Fig.2 zeigt eine schematische Darstellung einer Ausführungsform einer erfindungsgemäßen Lokalspulenmatrix 50. Die Lokalspulenmatrix 50 weist eine erste Spulenwicklung 51 und eine zweite Spulenwicklung 52 auf. Jeweils mit den Spulenwicklungen 51, 52 verbunden sind ein erster Vorverstärker 53 und ein zweiter Vorverstärker 53, die jeweils die durch die Spulenwicklungen 51, 52 empfangenen Magnetresonanzsignale verstärken. Bei dem ersten und dem zweiten Vorverstärkern 51, 52 handelt es sich um rauscharme Vorverstärker, die auch als LNA (low noise amplifier) bezeichnet werden. Üblicherweise werden im Stand der Technik die erste Spulenwicklung 51 und die zweite Spulenwicklung 52 resonant auf die Frequenz des Magnetresonanzsignals, die Larmorfrequenz, abgestimmt. Auf diese Weise wird die Signalamplitude maximiert. Der erste Vorverstärker 53 und der zweite Vorverstärker 54 werden dabei an die Impedanz der Spulenwicklungen 51, 52 angepasst, um ein optimales Signal-zu-Rausch-Verhältnis zu erzielen und nicht durch Reflexion einen Signalanteil zu verlieren.

Im Fall von relativ niedrigen statischen Magnetfeldern B0 wie bei der erfindungsgemäßen Lokalspulenmatrix 50, beispielsweise bei Werten von 1 T oder weniger, ist auch die Larmorfrequenz proportional zu dem statischen Magnetfeld B0 kleiner. Mit der abnehmenden Larmorfrequenz verringert sich aber auch in noch größerem Maß die Absorption für elektromagnetische Wechselfelder dieser Frequenz im menschlichen Körpergewebe. Die durch die erste Spulenwicklung 51 und die zweite Spulenwicklung 52 gebildeten Schwingkreise weisen daher bei der Anwendung am Patienten eine wesentlich geringere Dämpfung bei der Larmorfrequenz auf als bei Magnetresonanztomographen mit 1,5 T oder 3 T. Durch übergreifende magnetische Wechselfelder stehen dabei die Spulenwicklungen 51, 52 miteinander in Wechselwirkung, was zu einer Kopplung der Spulenresonanzen führt, die mit abnehmender Dämpfung durch das Körpergewebe bei niedrigeren Frequenzen zunimmt. Als Folge der Kopplung der Spulenwicklungen 51, 52 weist das gekoppelte System eine Aufspaltung der Resonanzfrequenzen **ω**0 auf zwei unterschiedliche Werte **ω**1 und **ω**2 auf. Der erste Vorverstärker 53 und den zweite Vorverstärker 54 der erfindungsgemäßen Lokalspulenmatrix 50 sind daher nicht mehr auf die Larmorfrequenz in ihrer Anpassung optimiert, sondern unter einer reduzierten Empfindlichkeit bei genau der Larmorfrequenz auf eine erhöhte Empfindlichkeit bei den Frequenzen **ω**1 und **ω**2**.** Im Stand der Technik ist dann bei einer schmalbandigen Anpassung die Empfindlichkeit bzw. das Signal-zu-Rauschverhältnis für Magnetresonanzsignale bei der Larmorfrequenz stark reduziert, beispielsweise um 6 oder 12 dB.

Die erfindungsgemäße Lokalspulenmatrix 50 hingegen weist eine Breitbandanpassung auf. Eine Abweichung der ersten und oder zweiten Resonanzfrequenz von der Larmorfrequenz um 100 kHz, 200 kHz oder 500 kHz führt dabei lediglich zu einer Verringerung des Signal-zu-Rauschabstandes (SNR) bei der Larmorfrequenz an dem Vorverstärker um weniger als 1 dB, 2 dB oder 3 dB. Ein derartiges Verhalten lässt sich beispielsweise durch eine gezielte Fehlanpassung erreichen. Dieses wird im Sinne der Erfindung als Breitbandanpassung des Verstärkers bezeichnet.

Die Breitbandanpassung lässt sich beispielsweise auch durch eine Messung des Stehwellenverhältnisses (SWR) überprüfen, das mittels Richtkopplern durch Messung der eingehenden und der reflektierten Hochfrequenzleistung am Eingang des Vorverstärkers bestimmt werden kann. Das Stehwellenverhältnis weicht dabei merklich von dem idealen Wert 1 ab und ist beispielsweise größer als 1,5, 2, 3 oder 5. Das Stehwellenverhältnis lässt sich auch rechnerisch aus den komplexen Impedanzen einerseits des Vorverstärkers und andererseits des Systems aus Spulenwicklung und Anpassungsnetzwerk bestimmen. Eine Breitbandanpassung entspricht dabei Abweichungen des Betrages der Impedanz des Systems aus Spulenwicklung und Anpassungsnetzwerk von dem Betrag der Eingangsimpedanz des Vorverstärkers um mehr als 20%, 70%, 200% oder 300%.

In Fig. 2 sind denkbare Anpassungsnetzwerk 55, 56 für einen Vorverstärker 53, 54 einer Ausführungsform der erfindungsgemäßen Lokalspulenmatrix 50 dargestellt. Zwischen der ersten Spulenwicklung 51 und dem ersten Vorverstärker 53 ist ein erstes Anpassungsnetzwerk 55 angeordnet. Das erste Anpassungsnetzwerk 55 ist hier als variables PI-Filter dargestellt, es sind aber auch andere Schaltungen zur Anpassung denkbar, beispielsweise Serien- oder Resonanzkreise. In der Ausführungsform der Fig. 2 sind dabei eine oder beide Kapazitäten des PI-Filters einstellbar. Vorzugsweise erfolgt eine Abstimmung durch eine Lokalspulensteuerung 57, um die Abstimmung der Lokalspule beispielsweise unterschiedlichen Anordnungen an einem Patienten anpassen zu können. Dies kann beispielsweise durch unterschiedliche Steuerspannungen an PIN-Dioden als Kapazitäten erfolgen.

Als Anpassungsnetzwerk sind aber auch andere Schaltungen denkbar. So lässt sich eine Änderung der Anpassung auch beispielsweise durch Parallel- und/oder Serienkapazitäten erreichen. Vorzugsweise sind diese als einstellbare Kapazitäten ausgelegt. Möglich wären aber auch komplexere Schaltungen wie beispielsweise Hilfsschwingkreise, die mit dem von der Spulenwicklung gebildeten Resonanzkreis gekoppelt sind.

In einem erfindungsgemäßen Verfahren stellt die Steuerung 20 des Magnetresonanztomographen 1 das einstellbare Anpassungsnetzwerk 55, 56 derart ein, dass eine Breitbandanpassung der Spulenwicklung 51, 52 an den Vorverstärker 53, 54 erfolgt. Es wäre beispielsweise denkbar, dass durch Variation der Einstellung des Anpassungsnetzwerkes 55, 56 das empfangene Signal optimiert wird. Denkbar wären auch zusätzliche Sensoren, beispielsweise zur Messung der Impedanz, des Stehwellenverhältnisses oder auch der Geometrie der Anordnung, mittels derer eine vorbestimmte Breitbandanpassung erzielt werden kann. Möglich ist auch die Verwendung von gespeicherten Einstellungswerten durch die Steuerung, insbesondere um die nachfolgend erläuterten Schwingungsmodi einzustellen.

Auf vorteilhafte Weise wirkt ein einstellbares Anpassungsnetzwerk 55, 56 auch auf die Schwingungsmoden der Spulenwicklungen 51, 52 zurück. So ist es in einer Ausführungsform denkbar, dass die Lokalspulensteuerung 57 und/oder die Steuerung 20 ausgelegt sind, Einstellungen des oder der Anpassungsnetzwerke 55, 56 so vorzunehmen, dass eine Schwingungsmode der beiden Spulenwicklungen mit vorbestimmter räumlicher Verteilung bevorzugt wird. Dies kann beispielsweise durch eine Veränderung der Resonanzfrequenz einer Mode durch das Anpassungsnetzwerk erreicht werden. Die einzelnen Moden unterscheiden sich in ihrer Resonanzfrequenz, sodass eine Mode, deren Resonanzfrequenz in Übereinstimmung mit der Larmorfrequenz gebracht wird, besonders stark zum Magnetresonanzsignal beiträgt. Auf diese Weise kann beispielsweise der bevorzugte Erfassungsbereich der Lokalspulenmatrix 50 zwischen einem oberflächensensitiven und einem tiefensensitiven Modus umgeschaltet werden.

In einer Ausführungsform ist es auch möglich, dass die Spulenwicklungen 51, 52 durch Entkopplungselemente 58 elektrisch miteinander verbunden sind. Jedoch sind die Entkopplungselemente auch mit elektrischen Verlusten behaftet, die die Empfindlichkeit der Lokalspulenmatrix 50 reduzieren. In einer denkbaren Ausführungsform der erfindungsgemäßen Lokalspulenmatrix ist die Lokalspulensteuerung 58 und/oder die Steuerung 20 ausgelegt, durch geeignete Wahl der bevorzugten Schwingungsmode einen Stromfluss durch das Entkopplungselement zu reduzieren, sodass auch der Verlust reduziert und die Güte verbessert wird.

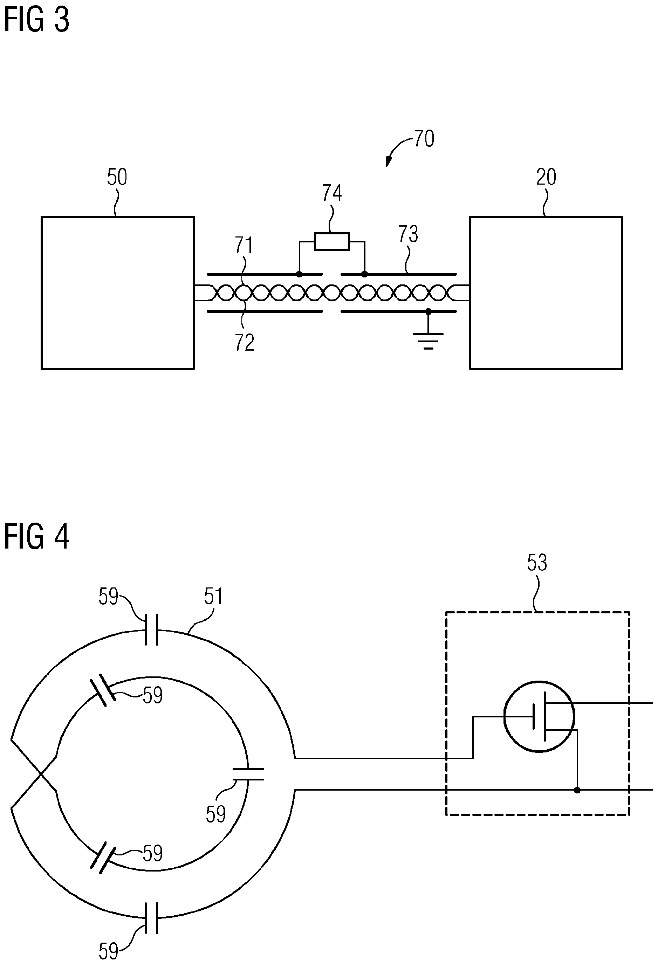

In Fig. 3 ist eine denkbare Ausführungsform einer Signalverbindung 70 einer erfindungsgemäßen Lokalspule 50 mit einer Steuerung 20 eines erfindungsgemäßen Magnetresonanztomographen 1 schematisch dargestellt.

Die Signalleitung 70 weist einen ersten Leiter 71 und einen zweiten Leiter 72 auf, die als symmetrische Leiter ausgeführt sind. Die beiden Leiter 71, 72 sind dabei in einem vorbestimmten Abstand zueinander, durch ein Dielektrikum voneinander isoliert geführt. Die beiden Leiter 71, 72 sind von einer gemeinsamen Abschirmung 73 umgeben. Derartige Signalleitungen 70 mit symmetrischen Leitern 71,72 sind beispielsweise als CAT-Kabel in der LAN-Verkabelung günstig verfügbar. Üblicherweise werden dabei der erste Leiter 71 und der zweite Leiter 72 als symmetrisches Leitungspaar genutzt, um ein symmetrisches Signal zu übertragen. Die vorliegende Signalleitung 70, die Lokalspulenmatrix 50 und die Steuerung 20 sind vorzugsweise jedoch dazu ausgelegt, die beiden Leiter 71 und 72 als getrennte Signalleiter für unterschiedliche asymmetrische Signale mit einer Bezugsmasse an der Abschirmung zu nutzen. Durch geeignete Wahl einer Länge der Signalleitung 70 und von sende- und empfangsseitigen Leitungsabschlüssen kann eine ausreichende Entkoppelung der asymmetrischen Signale erreicht werden, sodass keine kostenintensiven Koaxialleitungen verwendet werden müssen. Es ist aber auch eine Ausführungsform der Erfindung mit Signalübertragung über Koaxialleiter, optische Leiter oder auch drahtloser Übertragungstechnik denkbar.

Bei niedrigeren statischen Magnetfeldern B0 und damit verbundenen niedrigeren Larmorfrequenzen ist auch eine Ausbildung von stehenden Wellen auf einer Abschirmung der Signalleitung durch die relativ zur Leitungslänge größere Wellenlänge reduziert. Auf vorteilhafter Weise ist es daher bei der erfindungsgemäßen Signalleitung 70 auch möglich, anstelle von aufwändigen resonanten Mantelwellensperren auch einfache, ohmsche Mantelwellensperren zu verwenden, wie sie durch die Unterbrechung in der Abschirmung 73 und den überbrückenden Widerstand 74 angedeutet ist.

Als Steckverbinder zwischen der Signalleitung 70 und der Steuerung 20 sind dabei auch kostengünstige Vielfach-Stecker/Buchsen denkbar, die eine Matrix aus Kontaktstiften bzw. Verbindungskontakten in einer zweidimensionalen Anordnung aufweisen. Dabei sind der erste Leiter 71 und der zweite Leiter 72 sowie die Abschirmung 73 derart mit den Kontakten des Steckers bzw. der Buchse verbunden, dass ein mit dem ersten Leiter 71 verbundener Kontakt von Kontakten umgeben ist, die ohmsch mit der Abschirmung verbunden sind. Das gleiche gilt für den zweiten Leiter 72. Insbesondere ist der Kontakt in Verbindung mit dem ersten Leiter 71 nicht unmittelbar neben einem Kontakt in ohmscher Verbindung mit dem zweiten Leiter 72 angeordnet. Vorzugsweise ist hingegen zwischen diesen Kontakten zumindest ein weiterer Kontakt in ohmscher Verbindung mit der Abschirmung 73 angeordnet.

Auf diese Weise wird die Abschirmung 73 auch über eine Steckverbindung fortgesetzt und eine Wechselwirkung zwischen Signalleitern reduziert, ohne teure und aufwändig zu konfektionierende Koaxialstecker zu verwenden.

In einer möglichen Ausführungsform der Spulenwicklungen 51, 52 ist es dabei denkbar, dass eine oder beide aus Hochtemperatursupraleitern gefertigt sind, um die Empfangsgüte zu verbessern. Denkbare Materialien wären beispielsweise Hochtemperatursupraleiter oder Carbon-Nanoröhrchen bzw. Graphen.

In einer denkbaren Ausführungsform der erfindungsgemäßen Lokalspulenmatrix 50 sind die erste Spulenwicklung 51 und/oder die zweite Spulenwicklung 52 als Leiterbahnen auf einem flächigen Dielektrikum, beispielsweise eine starren oder flexiblen Leiterplatte angeordnet. Das Dielektrikum weist zwei gegenüberliegende Oberflächen auf, auf denen jeweils eine Leiterbahn angeordnet ist. Eine einzelne Spulenwicklung 71, 72 wird dabei jeweils durch zwei gegenüberliegende Leiterbahnen gebildet, die jeweils elektrisch mittels Querverbindungen, sogenannten Durchkontaktierungen, an einer oder mehreren Stellen durch das Dielektrikum miteinander verbunden sind. Auf diese Weise wird die Oberfläche der Leiterbahnen in Hinsicht auf Hochfrequenzleitung vergrößert, um Auswirkungen des Skin-Effekts zu reduzieren und die Güte der Spulenwicklung zu verbessern. Aufgrund der niedrigeren Larmorfrequenz bei dem niedrigeren statischen Magnetfeld sind vorteilhafter Weise die dielektrischen Verluste auch bei konventionellem Leiterplattenmaterial als Dielektrikum ausreichend gering.

In möglichen Ausführungsformen der Lokalspulenmatrix 50 ist es aber auch denkbar, dass eine Spulenwicklung 51 mehrere ohmsch voneinander isolierte Spulensegmente aufweist, wobei mindestens zwei der Segmente auf gegenüberliegenden Oberflächen des Dielektrikums angeordnet sind. Die beiden Segmente überlappen dabei, d.h. eine Projektion eines Segments auf die gegenüberliegende Oberfläche des Dielektrikums senkrecht zur Oberfläche weist eine Schnittmenge mit dem zweiten Segment der Spulenwicklung auf. Die überlappenden Segmente mit dem dazwischenliegenden Dielektrikum bilden auf vorteilhafte Weise eine Kapazität, die in Reihe mit der Induktivität der Antennenspule geschaltet ist.

Zur Kalibrierung und Homogenisierung der Magnetfelder werden sogenannte Magnetfeldkameras verwendet, bei denen für eine Probe über eine Bestimmung der Spin-Resonanzfrequenz die Stärke des Magnetfeldes bestimmt wird. Besonders einfach und kostengünstig lassen sich Magnetfeldkameras mit Proben aus einer Yttrium-Eisen-Granat-Verbindung (YIG) realisieren, das eine hohe Güte im Mikrowellenbereich und eine geringe Breite der Elektronenspin-Resonanz aufweist. Jedoch liegt die Elektronenspin-Resonanz für Magnetfelder von 1,5 T oder mehr im Bereich von mehreren 10 GHz und lässt sich nur mit hohem Aufwand auswerten. Bei dem erfindungsgemäßen Magnetresonanztomographen mit einem statischen Magnetfeld B0 von 1 T oder weniger ist die Elektronenspin-Resonanz jedoch in einem Frequenzbereich, für den Auswertungsschaltungen technisch und kommerziell gut verfügbar sind. Der erfindungsgemäße Magnetresonanztomograph weist daher in einer Ausführungsform eine oder mehrere Magnetfeldkameras mit einer YIG-Probe auf.

Vorzugsweise ist die Steuerung 20 des Magnetresonanztomographen 1 ausgelegt, mittels der Magnetfeldkamera das Magnetfeld an einem Ort im Patiententunnel 16 zu ermitteln, mit einem vorbestimmten Sollwert zu vergleichen und durch sog. Shimming auf den Sollwert zu bringen. Ein Shimming kann beispielsweise durch einstellbare Ströme in Korrekturspulen erreicht werden, die ein zusätzliches, überlagerndes Magnetfeld erzeugen.

In Fig. 4 ist eine beispielhafte Ausführungsform einer ersten Spulenwicklung 51 und eines ersten Vorverstärkers 53. In der Fig. 4 sind dabei nicht alle Elementen dargestellt, wie beispielsweise eine Stromversorgung oder Vorwiderstände, um die Übersichtlichkeit zu verbessern. Nicht dargestellt sind auch schaltungstechnische Maßnahmen zur Verstimmung während eines Anregungspulses des Magnetresonanztomographen 1.

Die erste Spulenwicklung 51 der Fig. 4 weist dabei mehrere Windungen auf, exemplarisch sind zwei Windungen dargestellt. In der ersten Spulenwicklung sind Verlängerungskapazitäten 59 vorgesehen, mit denen die erste Spulenwicklung 51 auch bei kleinen Abmessungen von wenigen Zentimetern bei der Larmorfrequenz in Resonanz gebracht werden kann. Durch die Mehrzahl an Spulenwindungen kann die Impedanz der ersten Spulenwicklung 51 erhöht werden. Typische Größenordnungen für die Impedanzen sind einige Ohm bis zu zweistelligen Werten für Spulen mit mehreren Windungen. Die Eingangsimpedanz typischer Vorverstärker mit rauscharmen FET-Transistoren wie beispielsweise E-PHEMT dagegen bewegt sich im Bereich von einigen Kiloohm.

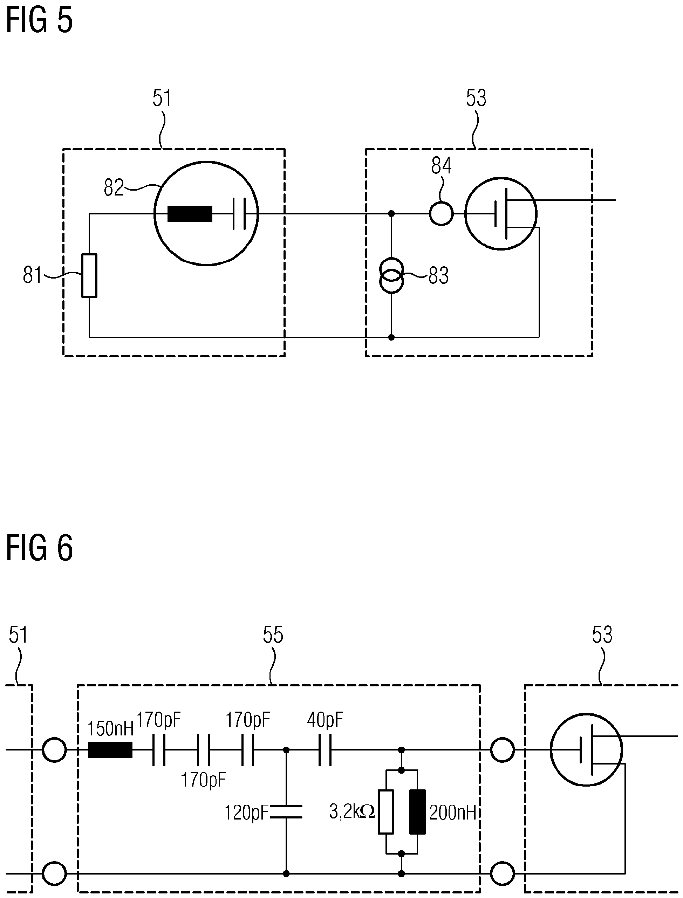

Fig. 5 zeigt ein Ersatzschaltbild für die Schaltung von Fig. 4 zum Abschätzen des von der Schaltung verursachten Rauschens. Die erste Spulenwicklung 51 wird dabei repräsentiert durch einen Realanteil der Impedanz, angegeben durch einen ohmschen Spulenwiderstand 81, und einen Imaginäranteil der Impedanz, dargestellt durch den komplexen Anteil 83 der Spulenimpedanz.

Der erste Vorverstärker 53 wird bei der Rauschbetrachtung durch eine Rauschspannungsquelle 83 und eine Rauschstromquelle 84 repräsentiert. Dabei erzeugt die Rauschstromquelle 84 eine reelle und damit störende Rauschspannung über den ohmschen Spulenwiderstand 81. Die an dem komplexen Anteil 82 durch den Rauschstrom erzeugte imaginäre Rauschspannung trägt nicht zu einer störenden Rauschleistung bei.

Üblicherweise wird versucht, mittels eines ersten Anpassungsnetzwerkes 55 die Ausgangsimpedanz der ersten Spulenwicklung 51 bei Resonanz, d.h. der Larmorfrequenz, auf den gleichen Wert wie die Eingangsimpedanz des ersten Vorverstärkers 53 zu transformieren. So kann bei der auf der Larmorfrequenz resonanten ersten Spulenwicklung 51 ein optimaler Signal-zu-Rauschabstand erzielt werden.

Bei einer Lokalspulenmatrix 50 ist dieser ideale Zustand jedoch die Ausnahme, insbesondere wenn es sich um Lokalspulenmatrizen mit variabler Geometrie handelt. Durch die Wechselwirkung mit dem Patienten 40 und benachbarten Spulenwicklungen in veränderlicher Lage wird die erste Spulenwicklung verstimmt. Durch die Verstimmung erfolgt eine Phasenverschiebung und der komplexe Anteil 82 der Spulenimpedanz erzeugt aus dem Rauschstrom der Rauschstromquelle 84 eine reelle Rauschspannung, die den Signal-zu-Rauschabstand verschlechtert. Dabei wird dieser Anteil durch die Impedanztransformation des ersten Anpassungsnetzwerkes 53 zu höheren Spannungswerten transformiert und trägt so überproportional zum Rauschen bei.

Bei der erfindungsgemäßen Lokalspulenmatrix 50 erfolgt deshalb eine Breitbandanpassung, bei der von der idealen Anpassung von Spulenimpedanz zu Eingangsimpedanz des ersten Vorverstärkers 53 abgewichen wird. In der in Fig. 4 dargestellten Ausführungsform wird auf ein Anpassungsnetzwerk 53 mit einer Impedanztransformation verzichtet. Im Extremfall ist es dabei denkbar, dass die erste Spulenwicklung 51 nur eine einzige Windung aufweist. Durch die niedrige Signalspannung der ersten Spulenwicklung 51 ist dabei eine sehr hohe Verstärkung des ersten Vorverstärkers 53 bei einer extrem niedrigen Rauschzahl des ersten Vorverstärkers 53 erforderlich, die beispielsweise bei Verwendung eine E-PHEMT als Transistor und/oder einer Kühlung des Verstärkers erreicht werden.

Ein Kompromiss mit einem besseren SNR bei Resonanz und einem dennoch guten Verhalten bei Verstimmung kann erreicht werden, indem bei der Breitbandanpassung die Ausgangsimpedanz der ersten Spulenwicklung 51 erhöht wird, aber dennoch deutlich, d.h. um Faktoren oder Größenordnungen unter der Eingangsimpedanz des ersten Vorverstärkers 53 gehalten wird. Eine Möglichkeit sind mehrere Spulenwindungen bei der ersten Spulenwicklung 51. Beispielsweise erhöht eine zweite Spulenwindung die Impedanz der ersten Spulenwicklung 51 um den Faktor 4.

Die Fig. 6 zeigt eine weitere Möglichkeit, diesen Kompromiss auszuführen. Dabei ist in der erfindungsgemäßen Lokalspulenmatrix 50 ein Anpassungsnetzwerk 55, 56 vorgesehen, das keine optimale Anpassung zwischen Antennenimpedanz und Vorverstärkereingangsimpedanz bei Resonanz vorsieht, sondern nur die Antennenausgangsimpedanz in Richtung der Vorverstärkereingangsimpedanz transformiert oder anhebt. Das optimale Verhältnis T (für Transformation) der Beträge von Vorverstärkereingangsimpedanz geteilt durch transformierter Antennenausgangsimpedanz hängt dabei von der Rauschzahl des ersten Vorverstärkers 53 ab. Je geringer diese ist, desto höher kann die Verstärkung durch den ersten Vorverstärker 53 sein, ohne das SNR bei Resonanz deutlich zu verschlechtern. Damit kann auch das Verhältnis T größer sein und das Vorverstärkerrauschen bei Verstimmung reduziert werden. Beispielhafte Werte für T können größer als 1000, 500, 200, 100 oder 50 sein.

Das in Fig. 6 beispielhaft dargestellte Anpassungsnetzwerk 55 ist für eine Frequenz von 64 MHz berechnet und transformiert eine Impedanz der ersten Spulenwicklung 51 von 0,8 Ohm in einen ausgangsseitigen Impedanzwert von 12 Ohm zum ersten Vorverstärker 53 hin. Insofern ist das Anpassungsnetzwerk vergleichbar der Impedanz einer Spulenwicklung mit mehreren (z.B. 4) Windungen. Es sind auch Varianten denkbar, bei denen Induktivitäten durch Kapazitäten ersetzt werden, beispielsweise die Spule zwischen Gate und Masse des Vorverstärkers. Dabei können aber Phasenverschiebungen auftreten.

Die zu Fig. 4, 5 und 6 gemachten Betrachtungen gelten in gleicher Weise für die zweite Spulenwicklung 52, den zweiten Vorverstärker 54 und das zweite Anpassungsnetzwerk sowie für weitere Spulenwicklungen und Vorverstärker der erfindungsgemäßen Lokalspulenmatrix.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Lokalspulenmatrix für einen Magnetresonanztomograph (1) mit niedrigem statischen Magnetfeld, wobei die Lokalspulenmatrix (50) eine erste Spulenwicklung (51) und eine zweite Spulenwicklung (52) und einen rauscharmen ersten Vorverstärker (53) und einen rauscharmen zweiten Vorverstärker (54) aufweist, wobei der erste Vorverstärker (53) mit der ersten Spulenwicklung (51) elektrisch verbunden ist und der zweite Vorverstärker (54) mit der zweiten Spulenwicklung (52) elektrisch verbunden ist, wobei die erste Spulenwicklung (51) eine Breitbandanpassung in einem ersten Frequenzbereich bei einer Larmorfrequenz an den damit verbundenen ersten Vorverstärker (53) aufweist, wobei als Breitbandanpassung eine Anpassung angesehen wird, die bei einer Abweichung einer Spulenresonanzfrequenz von der Larmorfrequenz um 1% eine Verringerung des Signal-zu-Rauschabstandes an dem Vorverstärker um weniger als 6 dB bei der Larmorfrequenz verursacht,
wobei die Lokalspulenmatrix (50) ein über eine Steuerverbindung einstellbares Anpassungsnetzwerk (55, 56) in Signalverbindung mit der ersten Spulenwicklung (51) und/oder der zweiten Spulenwicklung (52) aufweist,
**dadurch gekennzeichnet,**
**dass** die Lokalspulenmatrix (50) eine Lokalspulensteuerung (57) aufweist und die Lokalspulensteuerung (57) ausgelegt ist, Einstellungen des oder der Anpassungsnetzwerke (55, 56) so vorzunehmen, dass eine Schwingungsmode der beiden Spulenwicklungen (51, 52) mit vorbestimmter räumlicher Verteilung bevorzugt wird.

2. Lokalspulenmatrix nach Anspruch 1, wobei die erste Spulenwicklung (51) zur zweiten Spulenwicklung (52) benachbart angeordnet ist und die Spulenwicklungen (51, 52) je einen ersten Resonanzkreis und einen zweiten Resonanzkreis bilden und ein System aus erster Spulenwicklung (51) und zweiter Spulenwicklung (52) eine erste Resonanzfrequenz und eine zweite Resonanzfrequenz aufweist, wobei die erste Resonanzfrequenz und die zweite Resonanzfrequenz unterschiedlich sind und in dem ersten Frequenzbereich der Breitbandanpassung liegen.

3. Lokalspulenmatrix nach Anspruch 1 oder 2, wobei die erste Spulenwicklung (51) eine Mehrzahl an Windungen aufweist

4. Lokalspulenmatrix nach einem der Ansprüche 1 bis 3, wobei die Lokalspulenmatrix (50) ein Anpassungsnetzwerk (55) in Signalverbindung mit der ersten Spulenwicklung (51) und dem ersten Vorverstärker (53) aufweist, wobei die Impedanz des Systems aus Anpassungsnetzwerk (55) und erster Spulenwicklung (51) kleiner ist als eine Eingangsimpedanz des ersten Vorverstärkers (53).

5. Lokalspulenmatrix nach Anspruch 4, wobei das Anpassungsnetzwerk so ausgelegt ist, dass ein durch einen Rauschstrom des ersten Vorverstärkers (35) an der Impedanz des Systems aus Anpassungsnetzwerk (55, 56) und erster Spulenwicklung (51) bei einer Verstimmung der ersten Spulenwicklung verursachter Anstieg des Rauschens im Signal kleiner einem vorbestimmten Grenzwert ist.

6. Lokalspulenmatrix nach Anspruch 1, wobei das einstellbare erste Anpassungsnetzwerk (55) ausgelegt ist, die erste Resonanzfrequenz der ersten Spulenwicklung (51) und/oder die Breitbandanpassung des ersten Vorverstärkers (53) zu verändern, um die Empfindlichkeit der Lokalspulenmatrix auf eine vorgegebene Larmorfrequenz zu optimieren.

7. Lokalspulenmatrix nach Anspruch 1, wobei die erste Spulenwicklung (51) und die zweite Spulenwicklung (52) ein gemeinsames Spulenleitersegment und ein Entkopplungselement (58) aufweisen, wobei das Anpassungsnetzwerk (55, 56) derart einstellbar ist, eine Schwingungsmode in den Signalen der ersten Spulenwicklung (51) und der zweiten Spulenwicklung (52) zu bevorzugen, bei der ein Strom durch das Entkopplungselement (58) reduziert ist.

8. Lokalspulenmatrix nach einem der vorhergehenden Ansprüche, wobei die erste Spulenwicklung (51) ein erstes leitendes Segment und ein zweites leitendes Segment aufweisen, die elektrisch voneinander isolierte sind, wobei das erste leitende Segmente und das zweite leitende Segment jeweils eine Fläche aufweist, die miteinander überlappen und durch ein Dielektrikum voneinander isoliert sind.

9. Lokalspulenmatrix nach einem der vorhergehenden Ansprüche, wobei die Lokalspulenmatrix (50) eine Signalleitung (70) zum Anschluss an einen Magnetresonanztomographen aufweist, wobei die Signalleitung (70) eine ohmsche Mantelwellensperre (74) aufweist.

10. Lokalspulenmatrix nach einem der vorhergehenden Ansprüche, wobei die Lokalspulenmatrix (50) eine Signalleitung (70) zum Anschluss an einen Magnetresonanztomographen (1) aufweist, wobei die Signalleitung (70) eine symmetrische Zweidrahtleitung aufweist.

11. Lokalspulenmatrix nach einem der vorhergehenden Ansprüche, wobei die Lokalspulenmatrix (50) eine Signalleitung (70) zum Anschluss an einen Magnetresonanztomographen (1) aufweist, wobei die Signalleitung (70) einen Steckverbinder aufweist mit einer Mehrzahl an Signalkontakten, wobei die Mehrzahl an Signalkontakten jeweils von einer Mehrzahl an Massekontakten umgeben ist.

12. Lokalspulenmatrix nach einem der vorhergehenden Ansprüche, wobei die erste Spulenwicklung (51) einen Supraleiter, insbesondere einen Hochtemperatursupraleiter, und/oder Carbon-Nanoröhrchen aufweist.

13. Lokalspulenmatrix nach einem der vorhergehenden Ansprüche, wobei die erste Spulenwicklung (51) ein Dielektrikum mit zwei gegenüberliegenden Oberflächen aufweist, auf denen jeweils ein Leitermaterial der ersten Spulenwicklung (51) gegenüberliegend angeordnet ist, wobei das Leitermaterial auf den zwei gegenüberliegenden Oberflächen mittels einer Durchkontaktierung durch das Dielektrikum elektrisch leitend miteinander verbunden sind.

14. Magnetresonanztomograph mit einer Lokalspulenmatrix (50), wobei die Lokalspulenmatrix (50) eine erste Spulenwicklung (51) und eine zweite Spulenwicklung (52) und einen rauscharme ersten Vorverstärker (53) und einen rauscharmen zweiten Vorverstärker (54) aufweist, wobei der erste Vorverstärker (53) mit der ersten Spulenwicklung (51) elektrisch verbunden ist und der zweite Vorverstärker (54) mit der zweiten Spulenwicklung (52) elektrisch verbunden ist, wobei die erste Spulenwicklung (51) eine Breitbandanpassung in einem ersten Frequenzbereich bei einer Larmorfrequenz an den damit verbundenen ersten Vorverstärker (53) aufweist, wobei als Breitbandanpassung eine Anpassung angesehen wird, die bei einer Abweichung einer Spulenresonanzfrequenz von der Larmorfrequenz um 1% eine Verringerung des Signal-zu-Rauschabstandes an dem Vorverstärker um weniger als 6 dB bei der Larmorfrequenz verursacht,
wobei die Lokalspulenmatrix (50) ein über eine Steuerverbindung einstellbares Anpassungsnetzwerk (55, 56) in Signalverbindung mit der ersten Spulenwicklung (51) und/oder der zweiten Spulenwicklung (52) aufweist,
wobei der Magnetresonanztomograph (1) eine Steuerung (20) aufweist, **dadurch gekennzeichnet, dass** die Steuerung (20) ausgelegt ist, das Anpassungsnetzwerk (55, 56) über die Steuerverbindung derart einzustellen, dass eine vorbestimmte Schwingungsmode in den Signalen der ersten Spulenwicklung (51) und der zweiten Spulenwicklung (52) bevorzugt wird.

15. Magnetresonanztomograph nach Anspruch 14, wobei die Lokalspulenmatrix (50) ein Entkopplungselement (58) aufweist, wobei die erste Spulenwicklung (51) und die zweite Spulenwicklung (52) durch das Entkopplungselement (58) elektrisch miteinander verbunden sind, wobei die Steuerung ausgelegt ist, das Anpassungsnetzwerk (55, 56) über die Steuerverbindung derart einzustellen, dass eine Schwingungsmode in den Signalen der ersten Spulenwicklung (51) und der zweiten Spulenwicklung (52) bevorzugt wird, bei der ein Strom durch das Entkopplungselement (58) reduziert ist.

16. Magnetresonanztomograph nach einem der Ansprüche 14 oder 15, wobei der Magnetresonanztomograph (1) eine Magnetfeldkamera mit einer Yttrium-Eisen-Granat-Probe aufweist.

17. Verfahren zum Betrieb eines Magnetresonanztomographen (1) nach Anspruch 14, wobei das Verfahren den Schritt aufweist, durch die Steuerung (20) das einstellbare Anpassungsnetzwerk (55) derart einzustellen, dass eine vorbestimmte Schwingungsmode in den Signalen der ersten Spulenwicklung (51) und der zweiten Spulenwicklung (52) bevorzugt wird.

18. Verfahren zum Betrieb eines Magnetresonanztomographen (1) nach Anspruch 15, wobei das Verfahren den Schritt aufweist, durch die Steuerung (20) das einstellbare Anpassungsnetzwerk (55) derart einzustellen, dass eine Schwingungsmode aus den Signalen der ersten Spulenwicklung (51) und der zweiten Spulenwicklung (52) bevorzugt wird, bei der ein Strom durch das Entkopplungselement (58) reduziert ist.

19. Computerprogrammprodukt, welches direkt in einen Prozessor der Steuerung (20) des Magnetresonanztomographen (1) ladbar ist, mit Programmcode-Mitteln, um alle Schritte eines Verfahrens nach einem der Ansprüche 17 oder 18 auszuführen, wenn das Programmprodukt auf der Steuerung (20) ausgeführt wird.

20. Computerlesbares Speichermedium mit darauf gespeicherten elektronisch lesbaren Steuerinformationen, welche derart ausgestaltet sind, dass sie bei Verwendung des Speichermediums in der Steuerung (20) des Magnetresonanztomographen (1) das Verfahren nach einem der Ansprüche 17 oder 18 durchführen.

## Claims

1. Local coil matrix for a magnetic resonance tomography device (1) having low static magnetic field, wherein the local coil matrix (50) has a first coil winding (51) and a second coil winding (52) and a low-noise first preamplifier (53) and a low-noise second preamplifier (54), wherein the first preamplifier (53) is electrically connected to the first coil winding (51), and the second preamplifier (54) is electrically connected to the second coil winding (52), wherein the first coil winding (51) features broadband matching to the first preamplifier (53) connected thereto in a first frequency range at a Larmor frequency, wherein broadband matching is considered to be matching that for a deviation of a coil resonant frequency from the Larmor frequency by 1% causes a reduction of the signal-to-noise ratio at the preamplifier by less than 6 dB at the Larmor frequency,
wherein the local coil matrix (50) has a matching network (55, 56), which can be adjusted via a control connection and has a signal connection to the first coil winding (51) and/or to the second coil winding (52),
**characterised in that**
the local coil matrix (50) has a local-coil controller (57) and the local-coil controller (57) is designed to make adjustments to the matching network(s) (55, 56) so as to favour a resonant mode of the two coil windings (51, 52) having a predetermined spatial distribution.

2. Local coil matrix according to claim 1, wherein the first coil winding (51) is arranged adjacent to the second coil winding (52), and the coil windings (51, 52) respectively form a first resonant circuit and a second resonant circuit, and a system consisting of first coil winding (51) and second coil winding (52) has a first resonant frequency and a second resonant frequency, wherein the first resonant frequency and the second resonant frequency are different and lie in the first frequency range of the broadband matching.

3. Local coil matrix according to claim 1 or 2, wherein the first coil winding (51) has a plurality of turns.

4. Local coil matrix according to one of claims 1 to 3, wherein the local coil matrix (50) has a matching network (55), which has a signal connection to the first coil winding (51) and to the first preamplifier (53), wherein the impedance of the system consisting of matching network (55) and first coil winding (51) is smaller than an input impedance of the first preamplifier (53).

5. Local coil matrix according to claim 4, wherein the matching network is designed such that an increase in the noise in the signal, which increase is produced by a noise current of the first preamplifier (35) across the impedance of the system consisting of matching network (55, 56) and first coil winding (51) in the event of detuning of the first coil winding, is smaller than a predetermined limit value.

6. Local coil matrix according to claim 1, wherein the adjustable first matching network (55) is designed to change the first resonant frequency of the first coil winding (51) and/or the broadband matching of the first preamplifier (53), in order to optimise the sensitivity of the local coil matrix to a predefined Larmor frequency.

7. Local coil matrix according to claim 1, wherein the first coil winding (51) and the second coil winding (52) have a common coil-conductor segment and a decoupling element (58), wherein the matching network (55, 56) can be adjusted to favour in the signals from the first coil winding (51) and from the second coil winding (52), a resonant mode in which a current through the decoupling element (58) is reduced.

8. Local coil matrix according to one of the preceding claims, wherein the first coil winding (51) has a first conducting segment and a second conducting segment, which are electrically isolated from one another, wherein the first conducting segment and the second conducting segment have respective regions, which overlap one another and are isolated from one another by a dielectric.

9. Local coil matrix according to one of the preceding claims, wherein the local coil matrix (50) has a signal line (70) for connecting to a magnetic resonance tomography device, wherein the signal line (70) has an ohmic sheath current filter (74).

10. Local coil matrix according to one of the preceding claims, wherein the local coil matrix (50) has a signal line (70) for connecting to a magnetic resonance tomography device (1), wherein the signal line (70) has a symmetrical twin-conductor lead.

11. Local coil matrix according to one of the preceding claims, wherein the local coil matrix (50) has a signal line (70) for connecting to a magnetic resonance tomography device (1), wherein the signal line (70) has a plug-in connector having a plurality of signal contacts, wherein a plurality of ground contacts surround each of the plurality of signal contacts.

12. Local coil matrix according to one of the preceding claims, wherein the first coil winding (51) has a superconductor, in particular a high-temperature superconductor, and/or carbon nanotubes.

13. Local coil matrix according to one of the preceding claims, wherein the first coil winding (51) has a dielectric having two opposite surfaces, on each of which is arranged in an opposing manner a conductor material of the first coil winding (51), wherein each conductor material on the two opposite surfaces is connected to the other in an electrically conductive manner by means of a via through the dielectric.

14. Magnetic resonance tomography device having a local coil matrix (50), wherein the local coil matrix (50) has a first coil winding (51) and a second coil winding (52) and a low-noise first preamplifier (53) and a low-noise second preamplifier (54), wherein the first preamplifier (53) is electrically connected to the first coil winding (51), and the second preamplifier (54) is electrically connected to the second coil winding (52), wherein the first coil winding (51) features broadband matching to the first preamplifier (53) connected thereto in a first frequency range at a Larmor frequency, wherein broadband matching is considered to be matching that for a deviation of a coil resonant frequency from the Larmor frequency by 1% causes a reduction of the signal-to-noise ratio at the preamplifier by less than 6 dB at the Larmor frequency,
wherein the local coil matrix (50) has a matching network (55, 56), which can be adjusted via a control connection and has a signal connection to the first coil winding (51) and/or to the second coil winding (52),
wherein the magnetic resonance tomography device (1) has a controller (20), **characterised in that** the controller (20) is designed to adjust the matching network (55, 56) via the control connection in such a way as to favour a predetermined resonant mode in the signals from the first coil winding (51) and the second coil winding (52).

15. Magnetic resonance tomography device according to claim 14, wherein the local coil matrix (50) has a decoupling element (58), wherein the first coil winding (51) and the second coil winding (52) are connected electrically to one another by the decoupling element (58), wherein the controller is designed to adjust the matching network (55, 56) via the control connection in such a way as to favour in the signals from the first coil winding (51) and from the second coil winding (52), a resonant mode in which a current through the decoupling element (58) is reduced.

16. Magnetic resonance tomography device according to one of claims 14 or 15, wherein the magnetic resonance tomography device (1) has a magnetic field camera having an yttrium iron garnet sample.

17. Method for operating a magnetic resonance tomography device (1) according to claim 14, wherein the method has the step of the controller (20) adjusting the adjustable matching network (55) in such a way as to favour a predetermined resonant mode in the signals from the first coil winding (51) and from the second coil winding (52).

18. Method for operating a magnetic resonance tomography device (1) according to claim 15, wherein the method has the step of the controller (20) adjusting the adjustable matching network (55) in such a way as to favour from the signals from the first coil winding (51) and from the second coil winding (52), a resonant mode in which a current through the decoupling element (58) is reduced.

19. Computer program product, which can be loaded directly into a processor of the controller (20) of the magnetic resonance tomography device (1) and which contains program code means in order to perform all the steps of a method according to one of claims 17 or 18 when the program product is executed on the controller (20).

20. Computer-readable storage medium comprising electronically readable control information stored thereon, which information is designed to perform the method according to one of claims 17 or 18 when the storage medium is used in the controller (20) of the magnetic resonance tomography device (1).

## Revendications

1. Matrice de bobines locales d'un tomodensitomètre (1) à résonnance magnétique à champ magnétique statique faible, dans laquelle la matrice (50) de bobines locales a un premier enroulement (51) de bobine et un deuxième enroulement (52) de bobine et un premier préamplificateur (53) à faible bruit et un deuxième préamplificateur (54) à faible bruit, dans laquelle le premier préamplificateur (53) est relié électriquement au premier enroulement (51) de bobine et le deuxième préamplificateur (54) est relié électriquement au deuxième enroulement (52) de bobine, dans laquelle le premier enroulement (51) de bobine a une adaptation à bande large, dans une première plage de fréquence à une fréquence de Larmor, au premier préamplificateur (53) ainsi relié, dans laquelle il est considéré comme adaptation à bande large, une adaptation qui, à un écart d'une fréquence de résonnance de bobine de la fréquence de Larmor de 1%, provoque une diminution de la distance signal à bruit au préamplificateur de moins de 6 dB à la fréquence de Larmor,
dans laquelle la matrice (50) de bobines locales a un réseau (55, 56) d'adaptation réglable par une liaison de commande en liaison de signal avec le premier enroulement (51) de bobine et/ou le deuxième enroulement (52) de bobine,
**caractérisée**
**en ce que** la matrice (50) de bobines locales a une commande (57) de bobines locales et la commande (57) de bobines locales est conçue pour effectuer des réglages du ou des réseaux (55, 56) d'adaptation, de manière à ce qu'un mode d'oscillation des deux enroulements (51, 52) ayant une répartition dans l'espace définie à l'avance soit préféré.

2. Matrice de bobines locales suivant la revendication 1, dans laquelle le premier enroulement (51) de bobine est disposé au voisinage du deuxième enroulement (52) de bobine et les enroulements (51, 52) de bobine forment chacun un premier circuit de résonnance et un deuxième circuit de résonnance et un système composé du premier enroulement (51) de bobine et du deuxième enroulement (52) de bobine a une première fréquence de résonnance et une deuxième fréquence de résonnance, dans laquelle la première fréquence de résonnance et la deuxième fréquence de résonnance sont différentes et sont dans la première plage de fréquence de l'adaptation à bande large.

3. Matrice de bobines locales suivant la revendication 1 ou 2, dans laquelle le premier enroulement (51) de bobine a une pluralité de spires.

4. Matrice de bobines locales suivant l'une des revendications 1 à 3, dans laquelle la matrice (50) de bobines locales a un réseau (55) d'adaptation en liaison de signal avec le premier enroulement (51) de bobine et le premier préamplificateur (53), dans laquelle l'impédance du système, composée du réseau (55) d'adaptation et du premier enroulement (51) de bobine, est plus petite qu'une impédance d'entrée du premier préamplificateur (53).

5. Matrice de bobines locales suivant la revendication 4, dans laquelle le réseau d'adaptation est conçu de manière à ce qu'une augmentation du bruit dans le signal, provoquée par un courant de bruit du premier préamplificateur (35) à l'impédance du système composée du réseau (55, 56) d'adaptation et du premier enroulement (51) de bobine, lors d'un désaccord du premier enroulement de bobine, soit plus petite qu'une valeur limite définie à l'avance.

6. Matrice de bobines locales suivant la revendication 1, dans laquelle le premier réseau (55) d'adaptation est réglable pour modifier la première fréquence de résonnance du premier enroulement (51) de bobine et/ou l'adaptation à bande large du premier préamplificateur (53), afin d'optimiser la sensibilité de la matrice de bobines locales à une fréquence de Larmor donnée à l'avance.

7. Matrice de bobines locales suivant la revendication 1, dans laquelle le premier enroulement (51) de bobine et le deuxième enroulement (52) de bobine ont un segment conducteur de bobine commun et un élément (58) de découplage, dans laquelle le réseau (55, 56) d'adaptation est réglable, de manière à préférer un mode d'oscillation dans les signaux du premier enroulement (51) de bobine et du deuxième enroulement (52) de bobine, dans lequel un courant passant dans l'élément (58) de découplage est réduit.

8. Matrice de bobines locales suivant l'une des revendications précédentes, dans laquelle le premier enroulement (51) de bobine a un premier segment conducteur et un deuxième segment conducteur, qui sont isolés électriquement l'un de l'autre, dans laquelle le premier segment conducteur et le deuxième segment conducteur ont chacun une surface, qui se chevauchent l'une l'autre et qui sont isolées l'une de l'autre par un diélectrique.

9. Matrice de bobines locales suivant l'une des revendications précédentes, dans laquelle la matrice (50) de bobines locales a une ligne (70) de signal de raccordement à un tomodensitomètre à résonnance magnétique, dans laquelle la ligne (70) de signal a une barrière (74) ohmique aux ondes en gaine.

10. Matrice de bobines locales suivant l'une des revendications précédentes, dans laquelle la matrice (50) de bobines locales a une ligne (70) de signal de raccordement à un tomodensitomètre (1) à résonnance magnétique, dans laquelle la ligne (70) de signal a une ligne symétrique à deux fils.

11. Matrice de bobines locales suivant l'une des revendications précédentes, dans laquelle la matrice (50) de bobines locales a une ligne (70) de signal de raccordement à un tomodensitomètre (1) à résonnance magnétique, dans laquelle la ligne (70) de signal a un connecteur à enfichage ayant une pluralité de contacts de signal, dans laquelle la pluralité de contacts de signal est entourée respectivement d'une pluralité de contacts de masse.

12. Matrice de bobines locales suivant l'une des revendications précédentes, dans laquelle le premier enroulement (51) de bobine a un supraconducteur, notamment un supraconducteur à haute température et/ou des nanotubes de carbone.

13. Matrice de bobines locales suivant l'une des revendications précédentes, dans laquelle le premier enroulement (51) de bobine a un diélectrique ayant deux surfaces opposées, sur lesquelles est mis en opposition respectivement un matériau conducteur du premier enroulement (51) de bobine, dans laquelle les matériaux conducteurs sur les deux surfaces opposées sont reliés l'un à l'autre d'une manière conductrice de l'électricité, au moyen d'une traversée traversant le diélectrique.

14. Tomodensitomètre à résonnance magnétique ayant une matrice (50) de bobines locales,
dans lequel la matrice (50) a un premier enroulement (51) de bobine et un deuxième enroulement (52) de bobine et un premier préamplificateur (53) à faible bruit et un deuxième préamplificateur (54) à faible bruit, dans lequel le premier préamplificateur (53) est relié électriquement au premier enroulement (51) de bobine et le deuxième préamplificateur (54) est relié électriquement au deuxième enroulement (52) de bobine, dans lequel le premier enroulement (51) de bobine a une adaptation à bande large, dans une première plage de fréquence à une fréquence de Larmor au premier préamplificateur (53) ainsi relié, dans lequel il est considéré comme adaptation à bande large, une adaptation qui, à un écart d'une fréquence de résonnance de bobine de la fréquence de Larmor de 1%, provoque une diminution de la distance signal à bruit au préamplificateur de moins de 6 dB à la fréquence de Larmor,
dans lequel la matrice (50) de bobines locales a un réseau (55, 56) d'adaptation réglable par une liaison de commande en liaison de signal avec le premier enroulement (51) de bobine et/ou le deuxième enroulement (52) de bobine,
dans lequel le tomodensitomètre (1) à résonnance magnétique a une commande (20), **caractérisé en ce que** la commande (20) est conçue pour régler le réseau (55, 56) d'adaptation par la liaison de commande, de manière à ce qu'un mode d'oscillation défini à l'avance soit préféré dans les signaux du premier enroulement (51) de bobine et du deuxième enroulement (52) de bobine.

15. Tomodensitomètre à résonnance magnétique suivant la revendication 14,
dans lequel la matrice (50) de bobines locales a un élément (58) de découplage, dans lequel le premier enroulement (51) de bobine et le deuxième enroulement (52) de bobine sont reliés électriquement l'un à l'autre par l'élément (58) de découplage, dans lequel la commande est conçue pour régler le réseau (55, 56) d'adaptation par la liaison de commande, de manière à préférer dans les signaux du premier enroulement (51) de bobine et du deuxième enroulement (52) de bobine un mode d'oscillation, dans lequel un courant passant dans l'élément (58) de réglage est réduit.

16. Tomodensitomètre à résonnance magnétique suivant l'une des revendications 14 ou 15, dans lequel le tomodensitomètre (1) à résonnance magnétique a une caméra à champ magnétique ayant un échantillon de grenat d'yttrium - fer.

17. Procédé pour faire fonctionner un tomodensitomètre (1) à résonnance magnétique suivant la revendication 14, dans lequel le procédé comporte le stade,
régler, par la commande (20), le réseau (55) d'adaptation réglable, de manière à préférer, dans les signaux du premier enroulement (51) de bobine et du deuxième enroulement (52) de bobine, un mode d'oscillation défini à l'avance.

18. Procédé pour faire fonctionner un tomodensitomètre (1) à résonnance magnétique suivant la revendication 15, dans lequel le procédé comporte le stade
régler, par la commande (20), le réseau (55) d'adaptation réglable, de manière à préférer un mode d'oscillation composé des signaux du premier enroulement (51) de bobine et du deuxième enroulement (52) de bobine, dans lequel un courant passant dans l'élément (58) de découplage est réduit.

19. Produit de programme d'ordinateur, qui peut être chargé directement dans un processeur de la commande (20) du tomodensitomètre (1) à résonnance magnétique, comportant des moyens de code de programme pour effectuer tous les stades d'un procédé suivant l'une des revendications 17 ou 18, lorsque le produit de programme est réalisé sur la commande (20).

20. Support de mémoire, déchiffrable par ordinateur, sur lequel sont mises en mémoire des informations de commande, déchiffrables électroniquement, qui sont conformées de manière à ce qu'elles effectuent, lors de l'utilisation du support de mémoire dans la commande (20) du tomodensitomètre (1) à résonnance magnétique, le procédé suivant l'une des revendications 17 ou 18.
